# EUROPEAN PATENT APPLICATION

(11) **EP 4 583 650 A1**
(43) Date of publication of application: **09.07.2025**
(21) Application number: 24173736.0
(22) Date of filing: 02.05.2024
(51) Int. Cl.: H05K 7/20, F28F 3/04, F28F 9/02, F28F 13/08

(54) **LIQUID COOLING PLATE AND MOTOR CONTROLLER**

(30) Priority: 05.01.2024 CN 202410023317
(71) Applicant: Jing-Jin Electric Technologies Co., Ltd, Beijing 100023 (CN)
(72) Inventor: Ding, Ding, Beijing, 100023 (CN); Tian, Xiaokai, Beijing, 100023 (CN); Li, Wei, Beijing, 100023 (CN); Gallegos Lopez, Gabriel, Beijing, 100023 (CN); Zhang, Hao, Beijing, 100023 (CN)
(74) Representative: Schwarz & Partner Patentanwälte GmbH

(57) **Abstract**

A liquid cooling plate and a motor controller are provided. The liquid cooling plate comprises: a liquid cooling plate body (1000) laid flat inside the motor controller, wherein several installation grooves (103) for installing power modules are provided on an outer surface of the liquid cooling plate body (1000), and a first strip-shaped hole (104) and a second strip-shaped hole (105) are provided in each of the installation grooves (103); an inlet port (101) and an outlet port (102); a first liquid passage (131), wherein an inlet end of the first liquid passage (131) is communicated with the inlet port (101), and an outlet end of the first liquid passage (131) is communicated with the first strip-shaped hole (104); and a second liquid passage (132), wherein an inlet end of the second liquid passage (132) is communicated with the second strip-shaped hole (105), and an outlet end of the second liquid passage (132) is communicated with the outlet port (102). In the liquid cooling plate according to the present disclosure, by providing installation grooves (103) on the liquid cooling plate body (1000) and providing first and second strip-shaped holes (105) in the installation grooves (103), the liquid passages under power modules form a parallel structure. The coolant cools multiple power modules simultaneously during its flow process from the first strip-shaped holes (104) to the second strip-shaped holes (105), thereby improving the cooling effect of the power modules and keeping the temperature rise of the power modules uniform.

## Description

### TECHNICAL FIELD

The present disclosure relates to the technical field of motor controllers, in particular to a liquid cooling plate and a motor controller.

### BACKGROUND

The motor controller is a device that controls the energy transfer between the power supply and the driving motor, and consists of a control signal interface circuit, a driving motor control circuit, and a driving circuit. From the view of function, the motor controller of the new energy electric vehicle converts the direct current from the power battery of the new energy electric vehicle into the alternating current of the driving motor, communicates with the whole vehicle controller through the communication system, and controls the required speed and power of the vehicle.

The motor controller has a power module. Currently, silicon carbide power modules are gradually being applied in electric vehicles. In the existing motor controllers that use silicon carbide power modules, when there are a large number of (for example, six) silicon carbide power modules, a layout of two layers of liquid cooling plates is used to cool the silicon carbide power modules.

In the process of completing the present disclosure, the inventors found that there are at least the following problems in the prior art: the cooling of the power module by the two layers of liquid cooling plates is not uniform enough; the overall volume and installation space of the liquid cooling plates are quite large, which results in a larger volume of the entire motor controller; and the manufacturing process needs assembly twice, which affects the efficiency of production.

### SUMMARY

The present disclosure aims to solve at least one of the technical problems in the prior art to some extent.

Therefore, the present disclosure aims to provide a liquid cooling plate and a motor controller that can have good cooling effect of power modules, reduce the volume of the liquid cooling plate and reduce the required space for installation.

To achieve the above objects, a first aspect of the present disclosure provides a liquid cooling plate, comprising:
a liquid cooling plate body laid flat inside a motor controller, wherein several installation grooves for installing power modules are provided on an outer surface of the liquid cooling plate body, and a first strip-shaped hole and a second strip-shaped hole are provided in each of the installation grooves;
an inlet port and an outlet port provided on the liquid cooling plate body;
a first liquid passage, wherein an inlet end of the first liquid passage is communicated with the inlet port, and an outlet end of the first liquid passage is communicated with the first strip-shaped hole; and
a second liquid passage, wherein an inlet end of the second liquid passage is communicated with the second strip-shaped hole, and an outlet end of the second liquid passage is communicated with the outlet port.

In the liquid cooling plate according to the present disclosure, by providing installation grooves on the liquid cooling plate body and providing first and second strip-shaped holes in each of the installation grooves, the liquid passages under power modules form a parallel structure. The coolant cools multiple power modules simultaneously during its flow process from the first strip-shaped holes to the second strip-shaped holes, thereby improving the cooling effect of the power modules and keeping the temperature rise of the power modules uniform. The liquid cooling plate according to the present disclosure adopts a flat single-layer design, which saves the installation space of the liquid cooling plate without affecting its function. Moreover, it needs assembly only once, thereby improving the efficiency of production.

According to an embodiment of the present disclosure, the liquid cooling plate body comprises:
an upper plate, wherein the inlet port and the outlet port are provided on the upper plate, and upper halves of the first liquid passage and the second liquid passage are provided on a bottom of the upper plate; and
a lower plate welded to the upper plate, wherein lower halves of the first liquid passage and the second liquid passage are provided on a top of the lower plate.

According to the embodiment of the present disclosure, the installation grooves are symmetrically arranged along two sides of the upper plate, several first protrusions are provided at a middle part of the upper plate along a first direction, the first protrusions are used to place a heat conducting pad to dissipate heat from a copper bar; installation seats for installing AC insulation supports are provided at the middle part of the upper plate.

According to the embodiment of the present disclosure, the upper plate is provided with second protrusions for installing pressing plates, the second protrusions are provided on two sides of each of the installation grooves along the first direction, and a positioning pin is provided on each of the second protrusions located at four corners of the upper plate.

According to the embodiment of the present disclosure, first partition plates are provided on two sides of each of surfaces of the upper plate and the lower plate facing each other, the first partition plates isolate the first strip-shaped holes from the second strip-shaped holes, and the first liquid passage as a whole is L-shaped at a side of the liquid cooling plate body; second partition plates are provided on the liquid cooling plate body and at an inner side of the second strip-shaped holes, a third partition plate is provided at the middle part of the liquid cooling plate body, and the first partition plates, the second partition plates and the third partition plate divide the second liquid passage into a U-shape at a side of the liquid cooling plate body.

According to the embodiment of the present disclosure, a first liquid guiding plate is provided close to the inlet port in the first liquid passage.

According to the embodiment of the present disclosure, a liquid guiding plate assembly is provided between the third partition plate and each of the second partition plates.

According to the embodiment of the present disclosure, the liquid guiding plate assembly comprises a second liquid guiding plate, a third liquid guiding plate, and a fourth liquid guiding plate; the second liquid guiding plate, the third liquid guiding plate, and the fourth liquid guiding plate are separated from each other; the second liquid guiding plate is arranged along the first direction, and the third liquid guiding plate as a whole is L-shaped, and the fourth liquid guiding plate includes multiple segments.

According to the embodiment of the present disclosure, each of the second protrusions and the installation seats is provided with a protruding fastener base at the bottom of the upper plate, and the fastener base intersects or is separated from the first liquid guiding plate or the liquid guiding plate assembly.

A second aspect of the present disclosure provides a motor controller comprising power modules, a pressing plate, a copper bar, AC insulation supports, a capacitor, and a liquid cooling plate as described in the first aspect, wherein the power modules are located in the installation grooves; the pressing plate fastens the power modules; the AC insulation supports are located on the liquid cooling plate body; the copper bar is fixed on the AC insulation supports; the capacitor is located under the liquid cooling plate body.

The additional aspects and advantages of the present disclosure will be partially provided in the following description, some of which will become apparent from the following description, or will be understood through the practice of the present disclosure.

### BRIEF DESCRIPTION OF DRAWINGS

By reading the detailed description of the preferred embodiments below, various other advantages and benefits will become clear to a person of ordinary skill in the art. The accompanying drawings are only used for the purpose of illustrating the preferred embodiments, and should not be considered as a limitation to the present disclosure. Moreover, throughout the drawings, the same reference numerals are used to denote the same components. In the drawings:
FIG. 1 is a schematic diagram of the overall structure of a liquid cooling plate according to an embodiment of the present disclosure;
FIG. 2 is a schematic diagram of the bottom of the liquid cooling plate according to the embodiment of the present disclosure;
FIG. 3 is a schematic diagram of the internal structure of an upper plate of the liquid cooling plate according to the embodiment of the present disclosure; and
FIG. 4 is a schematic diagram of the internal structure of a lower plate of the liquid cooling plate according to the embodiment of the present disclosure.

In the drawings: 100, upper plate; 101, inlet port; 102, outlet port; 103, installation groove; 104, first strip-shaped hole; 105, second strip-shaped hole; 106, first protrusion; 107, second protrusion; 108, positioning pin; 109, connecting part; 111, installation seat; 112, positioning hole; 113, fastener base; 121, first liquid guiding plate; 122, first partition plate; 123, second partition plate; 124, second liquid guiding plate; 125, third liquid guiding plate; 126, fourth liquid guiding plate; 127, third partition plate; 131, first liquid passage; 132, second liquid passage; 200, lower plate; 1000, liquid cooling plate body.

### DETAILED DESCRIPTION

A detailed description of embodiments of the present disclosure is provided below. Examples of the embodiments are shown in the accompanying drawings, throughout which identical or similar reference numerals represent identical or similar components or components with identical or similar functions. The embodiments described below with reference to the accompanying drawings are illustrative and intended only to explain the present disclosure, and cannot be understood as limitations to the present disclosure. On the contrary, the embodiments of the present disclosure include all changes, modifications, and equivalents that fall within the scope of the spirit and content of the attached claims.

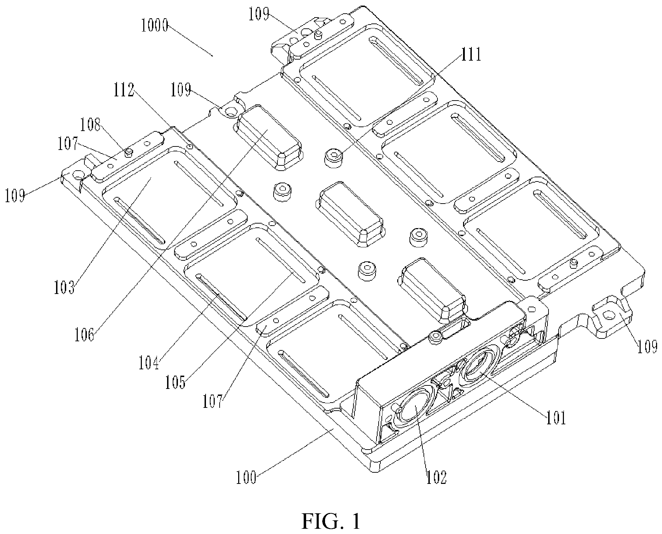

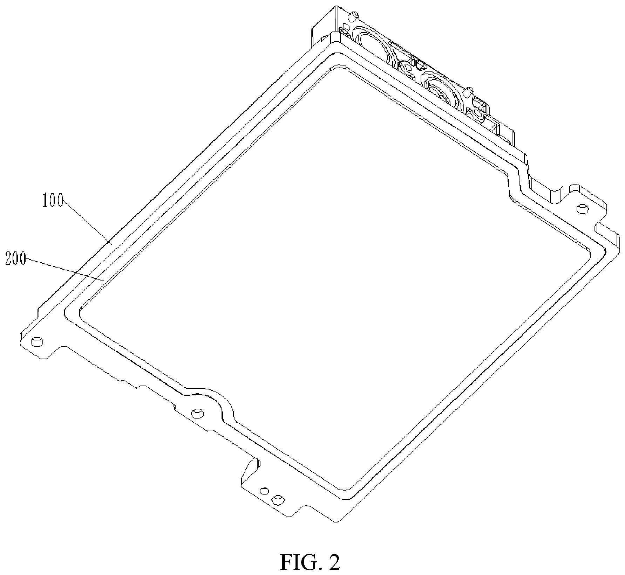

As shown in FIGS. 1 to 4, a first aspect of the present disclosure provides a liquid cooling plate comprising a liquid cooling plate body 1000, an inlet port 101 and an outlet port 102, a first liquid passage 131, and a second liquid passage 132.

The liquid cooling plate body 1000 is laid flat inside a motor controller. Several installation grooves 103 for installing power modules are provided on an outer surface of the liquid cooling plate body 1000, and a first strip-shaped hole 104 and a second strip-shaped hole 105 are provided in the installation groove 103. An inlet port 101 and an outlet port 102 are provided on the liquid cooling plate body 1000. An inlet end of the first liquid passage 131 is communicated with the inlet port 101, and an outlet end of the first liquid passage 131 is communicated with the first strip-shaped hole 104. An inlet end of the second liquid passage 132 is communicated with the second strip-shaped hole 105, and an outlet end of the second liquid passage 132 is communicated with the outlet port 102.

The coolant enters the first liquid passage 131 from the inlet port 101, flows into the first strip-shaped hole 104 in each installation groove 103, passes through the bottom of the power modules, dissipates heat from the power modules, then flows out from the second strip-shaped holes 105, enters the second liquid passage 132, flows out from the outlet port 102, and thus completes the circulation process in the liquid cooling plate body 1000. The liquid passages below multiple power modules (i.e., the liquid passages between the first strip-shaped holes 104 and the second strip-shaped holes 105) are a parallel structure, in which the coolant can maintain a uniform flow speed.

The liquid cooling plate body 1000 can be made of an aluminum alloy or copper. The positions of the inlet port 101 and the outlet port 102 are designed according to actual needs, which is not limited herein. For example, the inlet port 101 and the outlet port 102 may be adjacent to each other, which can reduce space occupation and facilitate maintenance. The power module may be a silicon carbide module, which has the merits of high efficiency, energy conservation, and environmental protection. The silicon carbide module as a whole is rectangular, and has two positioning pins at the bottom thereof.

In the liquid cooling plate according to the embodiment of the present disclosure, by providing installation grooves on the liquid cooling plate body and providing first and second strip-shaped holes in the installation grooves, the liquid passages under power modules form a parallel structure. The coolant cools multiple power modules simultaneously during its flow process from the first strip-shaped holes to the second strip-shaped holes, thereby improving the cooling effect of the power modules and keeping the temperature rise of the power modules uniform. The liquid cooling plate according to the embodiment of the present disclosure adopts a flat single-layer design, which saves the installation space of the liquid cooling plate without affecting its function. Moreover, it needs assembly only once, thereby improving the efficiency of production.

In some embodiments, the liquid cooling plate body 1000 comprises an upper plate 100 and a lower plate 200. The inlet port 101 and outlet port 102 are located on the upper plate 100, and the upper halves of the first liquid passage 131 and the second liquid passage 132 are provided on the bottom of the upper plate 100. The lower plate 200 is welded to the upper plate 100, and the lower halves of the first liquid passage 131 and the second liquid passage 132 are provided on the top of the lower plate 200. There are several connection parts 109 on the periphery of the upper plate 100, which are used for installation at fixed points on the motor control line.

From the perspective of thermal conductivity and economy, the upper plate 100 and the lower plate 200 can be made of the aluminum alloy ADC12. The upper plate 100 and the lower plate 200 are welded together using friction stir welding. The friction stir welding has a faster welding speed and can improve welding efficiency.

As shown in FIG. 1, the installation grooves 103 are symmetrically arranged along two sides of the upper plate 100. Several first protrusions 106 are provided at the middle part of the upper plate 100 along a first direction. The first protrusions 106 are used to place thermal conductive pads and dissipate heat from the copper bar. Installation seats 111 for installing AC insulation supports are provided at the middle part of the upper plate 100. A threaded hole is provided on the installation seat 111. The first direction may be the length direction of the liquid cooling plate body 1000. Positioning holes 112 are provided at a side of the installation grooves 103 that is close to the middle part of the upper plate 100. The positioning holes are used to accommodate positioning pins of the power modules. The copper bar is installed on the AC insulation supports, and the thermal conductive pad is in contact with the copper bar and the first protrusions 106, so the first protrusions 106 can take away the heat generated by the copper bar.

The number of installation grooves 103 is designed according to actual needs. In practical applications, a motor controller with a power of 500 kW or above needs six silicon carbide modules, so the number of installation grooves 103 is also six.

The upper plate 100 is provided with second protrusions 107 for installing pressing plates, the second protrusions 107 are provided on two sides of the installation groove 103 along the first direction, and a positioning pins 108 are provided on the second protrusions 107 located at four corners of the upper plate 100. The positioning pin 108 can limit the position of the pressing plate, and the second protrusion 107 is provided with a threaded hole. Under the action of fasteners, one pressing plate can fix three silicon carbide modules.

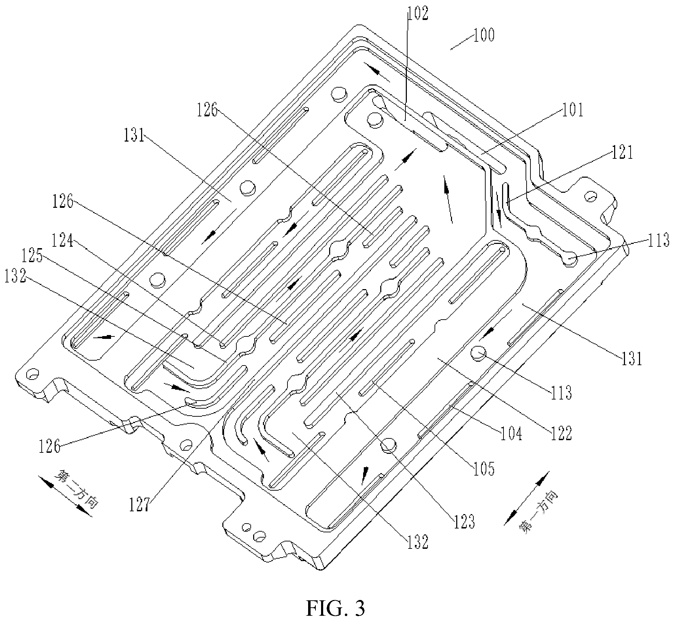

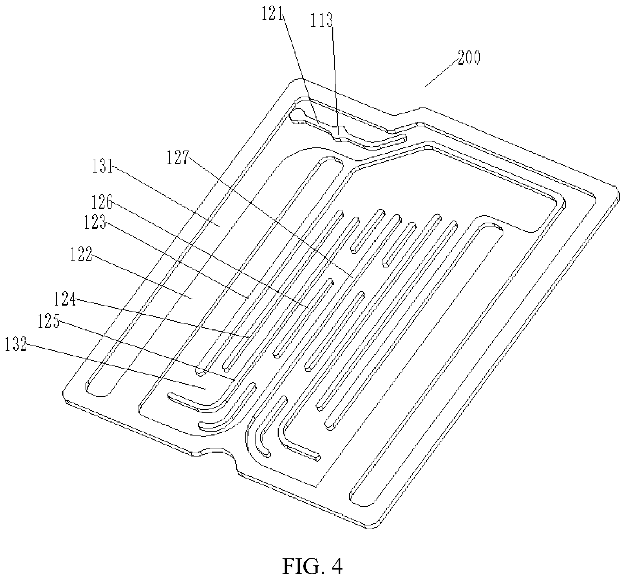

In some embodiments, as shown in FIGS. 3 and 4, first partition plates 122 are provided on two sides of each of surfaces of the upper plate 100 and the lower plate 200 facing each other, the first partition plates 122 isolate the first strip-shaped holes 104 from the second strip-shaped holes 105, and the first liquid passage 131 as a whole is L-shaped at a side of the liquid cooling plate body 1000. Second partition plates 123 are provided on the liquid cooling plate body 1000 and at an inner side of the second strip-shaped holes 105, a third partition plate 127 is provided at the middle part of the liquid cooling plate body 1000, and the first partition plates 122, the second partition plates 123, and the third partition plate 127 divide the second liquid passage 132 into a U-shape at a side of the liquid cooling plate body 1000.

The first partition plates 122 allow the coolant to flow entirely below the power modules, and thus allow heat to be fully dissipated from the power modules. The second partition plates 123 and the third partition plate 127 can enable the coolant to change the flowing direction in the second liquid passage 132, and flow through the middle part of the entire liquid cooling plate body 1000, thereby improving the heat dissipation effect for various devices on the liquid cooling plate body 1000.

In addition, a first liquid guiding plate 121 is provided close to the inlet port 101 in the first liquid passage 131. The first liquid guiding plate 121 has a bend, which can divert the coolant, reduce the coolant flow speed, avoid turbulence, and alleviate the impact at a corner of the first liquid passage 131.

A liquid guiding plate assembly is provided between the second partition plate 123 and the third partition plate 127. The liquid guiding plate assembly comprises a second liquid guiding plate 124, a third liquid guiding plate 125, and a fourth liquid guiding plate 126. The second liquid guiding plate 124, the third liquid guiding plate 125, and the fourth liquid guiding plate 126 are separated from each other, and the second liquid guiding plate 124 is arranged in the first direction. The third liquid guiding plate 125 as a whole is L-shaped, and the fourth liquid guiding plate 126 includes multiple sections. The second guiding plate 124, the third guiding plate 125, and the fourth guiding plate 126 play a role of guiding the coolant, and can reduce the coolant flow speed, alleviate the impact on the corners of the second liquid passage 132, and also reduce turbulence inside the second liquid passage 132, thereby improving the stability of the liquid cooling plate.

Each of the second protrusions 107 and the installation seats 111 is provided with a protruding fastener base 113 at the bottom of the upper plate 100, and the fastener base 113 intersects or is separated from the first liquid guiding plate 121 or the liquid guiding plate assembly. The fastener base 113 can deepen the effective connection depth of the fastener and improve the fixation effect of the power modules and the copper bar. The fastener bases 113 that intersect with the first guiding plate 121 or the guiding plate assembly can reduce the width between adjacent guiding plates. In order to make the flow of coolant more stable, the fourth guiding plate 126 adopts a multi-segment design, and the gaps between segments are adjacent to the fastener bases 113, which can reduce the pressure difference of coolant at the inlet and outlet ports, thereby achieving the predetermined pressure difference and flow speed.

Based on the above purpose, a second aspect of the present disclosure provides a motor controller comprising power modules, a pressing plate, a copper bar, AC insulation supports, a capacitor, and the liquid cooling plate as described in the first aspect. The power modules are located in the installation grooves 103; the pressing plate fastens the power modules; the AC insulation supports are located on the liquid cooling plate body 1000; the copper bar is fixed on the AC insulation supports; the capacitor is located under the liquid cooling plate body 1000.

The motor controller according to the embodiment of the present disclosure, by adopting a single liquid cooling plate, and adopting the flat and parallel liquid passage layout inside the liquid cooling plate, solves the problem of uneven temperature rise of power modules and poor cooling effect when there are a large number of power modules. Moreover, it can effectively reduce the risk of overheating and burning of components in the motor controller, and also have a good heat dissipation effect for capacitors and copper bars.

It should be noted that in the description of the present disclosure, the terms "first", "second", etc. are only used for descriptive purposes and should not be understood as indicating or implying relative importance. Furthermore, in the description of the present disclosure, unless otherwise specified, "multiple" or "a plurality of" means two or more.

In the present disclosure, unless otherwise specified and defined, the terms such as "installation", "connection", "fixation" should be understood in a broad sense, for example, it may be fixedly connected, or detachably connected, or integrally connected; it may also be mechanically connected, electrically connected, or communicated with each other; it may be directly connected or indirectly connected through a middleware; it may also be internally communicated or interacted between two components. For a person of ordinary skill in the art, the specific meaning of these terms in the present disclosure should be understood according to specific situations.

In the present disclosure, unless otherwise specified and defined, the first feature is located "on" or "beneath" the second feature may be that the first and second features are in direct contact or in indirect contact through an intermediate medium. Moreover, the first feature is "above" the second feature may be that the first feature is directly or diagonally above the second feature, or only indicate that the first feature is horizontally higher than the second feature. The first feature "below" or "under" the second feature may be that the first feature is directly or diagonally below the second feature, or only indicate that the horizontal height of the first feature is less than that of the second feature.

In the description of the present disclosure, the terms "left", "right", "front", "back", etc. indicate the orientation or position relationship based on the orientation or position relationship shown in the drawings, only for the convenience of describing the present disclosure and simplifying the description, and not to indicate or imply that the device or element referred to must have a specific orientation, be constructed and operated in a specific orientation, and therefore cannot be understood as a limitation of the present disclosure.

The description of any process or method in a flowchart or otherwise described herein may be understood as comprising one or more modules, fragments, or portions of codes of executable instructions for implementing specific logical functions or procedures, and the scope of preferred embodiments of the present disclosure comprises other implementations, which may not be in the order shown or discussed, including performing functions in a fundamentally simultaneous manner or in reverse order based on the functions involved. This should be understood by those skilled in the art.

In the description of this specification, terms such as "an embodiment", "some embodiments", "an example", "a specific example", or "some examples" means that the specific features, structures, materials, or features described in conjunction with the embodiments or examples are included in at least one embodiment or example of the present disclosure. In this specification, the illustrative description of the above terms may not necessarily refer to the same embodiments or examples. Moreover, the specific features, structures, materials, or characteristics described can be combined in an appropriate manner in any one or more embodiments or examples.

Although embodiments of the present disclosure have been shown and described above, it can be understood that the above embodiments are exemplary and cannot be understood as a limitation of the present disclosure. A person of ordinary skill in the art may make changes, modifications, substitutions, and variations to the above embodiments within the scope of the present disclosure.

## Claims

1. A liquid cooling plate, **characterized by** comprising:
a liquid cooling plate body (1000) laid flat inside a motor controller, wherein several installation grooves (103) for installing power modules are provided on an outer surface of the liquid cooling plate body (1000), and a first strip-shaped hole (104) and a second strip-shaped hole (105) are provided in each of the installation grooves (103);
an inlet port (101) and an outlet port (102) provided on the liquid cooling plate body (1000);
a first liquid passage (131), wherein an inlet end of the first liquid passage (131) is communicated with the inlet port (101), and an outlet end of the first liquid passage (131) is communicated with the first strip-shaped hole (104); and
a second liquid passage (132), wherein an inlet end of the second liquid passage (132) is communicated with the second strip-shaped hole (105), and an outlet end of the second liquid passage (132) is communicated with the outlet port (102).

2. The liquid cooling plate according to claim 1, **characterized in that**: the liquid cooling plate body (1000) comprises:
an upper plate (100), wherein the inlet port (101) and the outlet port (102) are provided on the upper plate (100), and upper halves of the first liquid passage (131) and the second liquid passage (132) are provided on a bottom of the upper plate (100); and
a lower plate (200) welded to the upper plate (100), wherein lower halves of the first liquid passage (131) and the second liquid passage (132) are provided on a top of the lower plate (200).

3. The liquid cooling plate according to claim 2, **characterized in that**: the installation grooves (103) are symmetrically arranged along two sides of the upper plate (100), several first protrusions (106) are provided at a middle part of the upper plate (100) along a first direction, and the first protrusions (106) are used to place a heat conducting pad to dissipate heat from a copper bar;
installation seats (111) for installing AC insulation supports are provided at the middle part of the upper plate (100).

4. The liquid cooling plate according to claim 3, **characterized in that**: the upper plate (100) is provided with second protrusions (107) for installing pressing plates, the second protrusions (107) are provided on two sides of each of the installation grooves (103) along the first direction, and a positioning pin (108) is provided on each of the second protrusions (107) located at four corners of the upper plate (100).

5. The liquid cooling plate according to claim 4, **characterized in that**: first partition plates (122) are provided on two sides of each of surfaces of the upper plate (100) and the lower plate (200) facing each other, the first partition plates (122) isolate the first strip-shaped holes (104) from the second strip-shaped holes (105), and the first liquid passage (131) as a whole is L-shaped at a side of the liquid cooling plate body (1000);
second partition plates (123) are provided on the liquid cooling plate body (1000) and at an inner side of the second strip-shaped holes (105), a third partition plate (127) is provided at the middle part of the liquid cooling plate body (1000), and the first partition plates (122), the second partition plates (123) and the third partition plate (127) divide the second liquid passage (132) into a U-shape at a side of the liquid cooling plate body (1000).

6. The liquid cooling plate according to claim 5, **characterized in that**: a first liquid guiding plate (121) is provided close to the inlet port (101) in the first liquid passage (131).

7. The liquid cooling plate according to claim 6, **characterized in that**: a liquid guiding plate assembly is provided between the third partition plate (127) and each of the second partition plates (123).

8. The liquid cooling plate according to claim 7, **characterized in that**: the liquid guiding plate assembly comprises a second liquid guiding plate (124), a third liquid guiding plate (125), and a fourth liquid guiding plate (126); the second liquid guiding plate (124), the third liquid guiding plate (125), and the fourth liquid guiding plate (126) are separated from each other; the second liquid guiding plate (124) is arranged along the first direction, the third liquid guiding plate (125) as a whole is L-shaped, and the fourth liquid guiding plate (126) includes multiple segments.

9. The liquid cooling plate according to claim 7, **characterized in that**: each of the second protrusions (107) and the installation seats (111) is provided with a protruding fastener base (113) at the bottom of the upper plate (100), and the fastener base (113) intersects or is separated from the first liquid guiding plate (121) or the liquid guiding plate assembly.

10. A motor controller, comprising power modules, a pressing plate, a copper bar, AC insulation supports, a capacitor, and a liquid cooling plate according to any one of claims 1 to 9, **characterized in that**: the power modules are located in the installation grooves (103); the pressing plate fastens the power modules; the AC insulation supports are located on the liquid cooling plate body (1000); the copper bar is fixed on the AC insulation supports; the capacitor is located under the liquid cooling plate body (1000).
